# EUROPEAN PATENT APPLICATION

(11) **EP 1 411 363 A2**
(43) Date of publication of application: **21.04.2004**
(21) Application number: 03023313.4
(22) Date of filing: 15.10.2003
(51) Int. Cl.: G01R 31/316, G01R 31/319, G01R 1/073

(54) **Prober**

(30) Priority: 18.10.2002 JP 2002304711
(71) Applicant: TOKYO ELECTRON LIMITED, Minato-ku, Tokyo 107-8481 (JP)
(72) Inventor: Noguchi, Masayuki, Nirasaki-shi Yamanashi 407-8511 (JP)
(74) Representative: Gleiss, Alf-Olav, Dipl.-Ing.

(57) **Abstract**

A prober (60) of this invention includes a head plate (27). On the head plate (60), a mounting mechanism (60) for mounting a test head (TH) is placed. The mounting mechanism (60) can include a plurality of types of mounting member (e.g., a fixing plate (31A), guide pins (31), and screw holes (27A, 27B)) for mounting one of a plurality of types of the test head. The head plate (27) includes a card holding mechanism (26) (card clamp). The card clamp (26) detachably supports a probe card (24) and POGO ring (25).

## Description

The present invention relates to a prober and, more particularly, to a prober to which one of a plurality of types of POGO rings and one of a plurality of test heads can be attached.

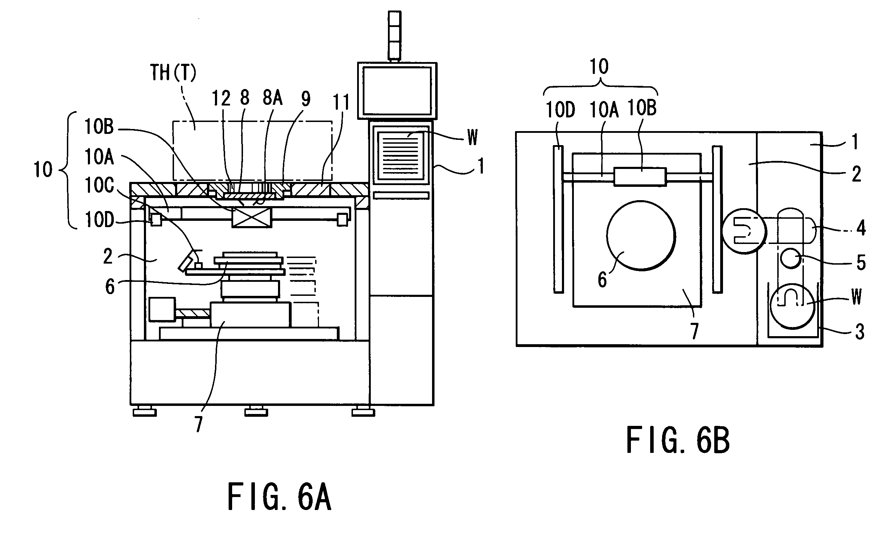

A prober is used to test the electrical characteristics of a device formed on a wafer in the semiconductor device fabrication process. As shown in FIGS. 6A and 6B, this prober includes a loader chamber 1 for loading wafers W, and a prober chamber 2 for testing the electrical characteristics of the wafers W transferred from the loader chamber 1. The loader chamber 1 can include a cassette storage unit 3, a wafer transporting mechanism 4 for transporting the wafers W to the loader chamber 1, and a sub-chuck 5 for prealigning each wafer W with reference to an orientation flat or notch of the wafer W while the wafer W is transported.

The prober chamber 2 includes a main chuck 6 on which the prealigned wafer W is placed from the wafer transporting mechanism 4, an X-Y table 7 for moving the main chuck 6 in the X and Y directions, a probe card 8 positioned above the main chuck 6, a card holding mechanism (referred to hereinafter as a "card clamp") 9 for detachably holding the probe card 8, and an alignment mechanism 10 for accurately aligning probe pins 8A of the probe card 8 with electrode pads of a semiconductor element (device) on the wafer W placed on the main chuck 6. The alignment mechanism 10 can include an upper camera 10B attached to an alignment bridge 10A to sense an image of the wafer W, and a lower camera 10C mounted on the main chuck 6 to sense an image of the probe pin 8A. The alignment bridge 10A can advance from a rear end position to a probe center position in the center of the prober chamber 2 along a pair of guide rails 10D.

As shown in FIG. 6A, a test head TH is placed on the prober chamber 2. A tester can also be placed in the test head TH. The card clamp 9 is attached to an opening of a head plate 11 at the upper end of the prober chamber 2. The card clamp 9 detachably holds the probe card 8. The test head TH is rotatably mounted on the head plate 11. The test head TH and probe card 8 are electrically connected via a POGO ring 12 held by the card clamp 9. A test signal from a tester T is transmitted to the probe pins 8A via the test head TH and POGO ring 12. By this test signal transmitted from the probe pins 8A to the electrode pads of the wafer W, the electrical characteristics of a plurality of devices formed on the wafer W are tested.

The contents of the test and the number and the pattern of arrangement of electrode pads depend on the type of device. Accordingly, it is necessary to selectively use a plurality of testers in accordance with the contents of a device test. Each of these plurality of testers has a dedicated test head and performance board. The prober has the probe card 8 and POGO ring 12 for a specific tester. Therefore, the probers have a one-to-one correspondence with the testers.

As described above, the prober has a structure which can be connected only to a specific tester. To connect a prober connectable only to a specific tester to another tester, it is necessary to prepare the POGO ring 12 and probe card 8 corresponding to the performance board of the other tester. However, the number, arrangement, and outer shape of POGO pins of the POGO ring 12 depend on the type of tester. To connect the prober to the other tester, therefore, it is necessary to largely modify the connecting structure, e.g., change the design of the structure of the card clamp 9 for connecting the POGO ring 12 and probe card 8, in accordance with the POGO ring 12. In recent years especially, semiconductor devices have diversified, so small quantities of various products are fabricated. Accordingly, device tests have also diversified, and this has increased the types of testers and probers.

To solve this problem, a connecting structure in which an adapter ring is interposed between a POGO ring and inner ring (equivalent to the card clamp) is proposed (Jpn. Pat. Appln. KOKAI Publication No. 2000-349128, paragraph [0013], lines 1 to 6). When a tester is changed, this connecting structure holds the POGO ring by the inner ring via the adapter. As a consequence, the inner ring can be kept used without any modification.

In this connecting structure described in Jpn. Pat. Appln. KOKAI Publication No. 2000-349128, the adapter ring is interposed between the POGO ring and inner ring. This adapter ring makes one inner ring usable for a plurality of types of POGO rings. However, since the adapter ring protrudes from the upper surface of the head plate, the flatness of the head plate deteriorates.

The adapter ring is directly fixed to the head plate, so the size of the adapter ring increases. This makes the manufacture and handling of the adapter ring difficult.

That is, a mounting member for fixing the test head to the head plate must be designed and installed for each test head.

Similar to patent reference 1, a universal tooling plate for connecting a plurality of test heads to one prober is proposed (Systematic website [accessed July 19, 2002] (URL:http://www-probersolutions. com/id1_m.htm)).

Connecting parts for various test heads can be attached to this universal tooling plate. However, a new universal tooling plate must be attached to the head plate whenever the test head is replaced.

It is an object of the present invention to solve at least one of the problems of the prior art references described above.

The present invention provides a prober capable of accepting at least two of a plurality of types of test head by minimum design change and modification.

According to a first aspect of the present invention, there is provided a prober for electrically connecting a probe card to a test head via a POGO ring. This prober comprises:
a head plate fixed on the prober;
a mounting mechanism placed on the head plate to mount a test head (the mounting mechanism comprises a plurality of types of mounting member corresponding to one of a plurality of types of test head);
a card holding mechanism to be mounted on the head plate (the card holding mechanism detachably holds the probe card and the POGO ring placed on the probe card); and
a connecting ring (the connecting ring is interposed between the card holding mechanism and POGO ring, the card holding mechanism holds the POGO ring via the connecting ring, and the connecting ring adaptive to a structure of the card holding mechanism and a structure of the POGO ring is selected from a plurality of types of connecting ring).

The prober provided according to the first aspect preferably comprises one or a combination of some of items (a) to (c) below.
(a) The level of an upper surface of at least one of the plurality of types of connecting ring is equal to or lower than the level of an upper surface of the card holding mechanism.
(b) The connecting ring has a flange to hold a POGO pin inside a ring structure of the connecting ring.
(c) The prober further comprises a ring-like member to mount the card holding mechanism to the head plate.

According to a second aspect of the present invention, there is provided a prober for electrically connecting a probe card to a test head via a POGO ring. This prober comprises:
a head plate fixed on the prober;
a card holding mechanism to be mounted on the head plate (the card holding mechanism detachably holds the probe card and the POGO ring placed on the probe card); and
a connecting ring (the connecting ring is interposed between the card holding mechanism and POGO ring, the card holding mechanism holds the POGO ring via the connecting ring, the connecting ring adaptive to a structure of the card holding mechanism and a structure of the POGO ring is selected from a plurality of types of connecting ring, and the level of an upper surface of at least one of the plurality of types of connecting ring is equal to or lower than the level of an upper surface of the card holding mechanism).

The prober provided according to the second aspect of the present invention preferably comprises one or a combination of some of items (d) to (f) below.
(d) The connecting ring has a flange to hold a POGO pin inside a ring structure of the connecting ring.
(e) The prober further comprises a ring-like member to mount the card holding mechanism to the head plate.
(f) The inner circumferential surface of the connecting ring engages with the outer circumferential surface of each POGO ring, and also engages with the card holding mechanism.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a view showing the external appearance of an embodiment of a prober of the present invention;
FIGS. 2A and 2B are a plan view and sectional view, respectively, showing the main parts of a prober chamber shown in FIG. 1;
FIG. 3 is a sectional view showing a head plate shown in FIG. 2B in an enlarged scale;
FIGS. 4A to 4C are sectional views showing different POGO rings to which their own connecting rings are attached;
FIGS. 5A and 5B are views showing the state in which the POGO ring shown in FIG. 4B is attached to the head plate shown in FIG. 3, in which FIG. 5A is equivalent to FIG. 2A, and FIG. 5B is equivalent to FIG. 2B; and
FIGS. 6A and 6B are views showing an example of a conventional prober, in which FIG. 6A is a partially exploded front view of the prober, and FIG. 6B is a plan view of the prober.

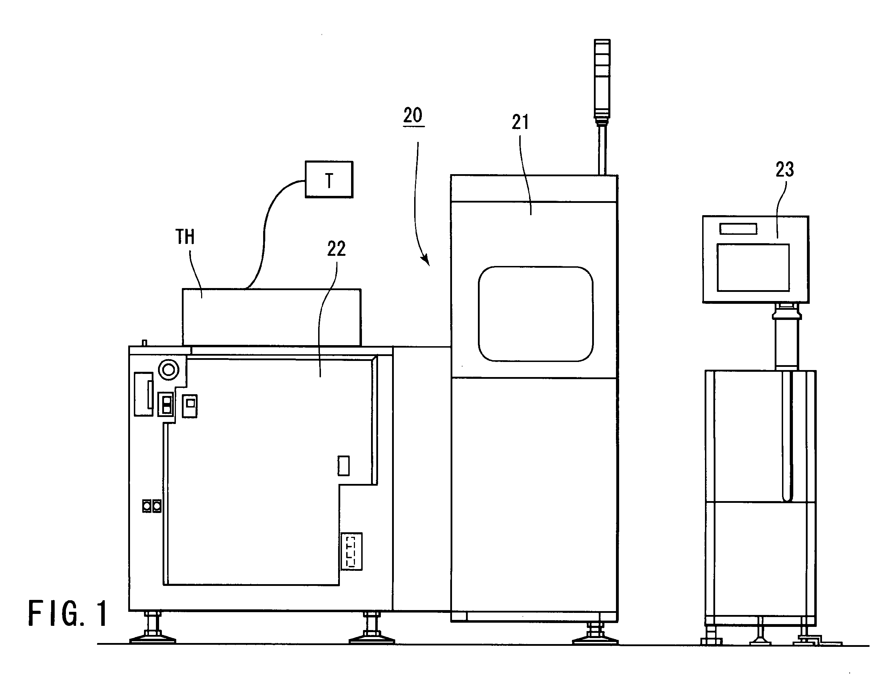

The present invention will be described below on the basis of an embodiment shown in FIGS. 1 to 5B.

The present invention is a prober for testing the electrical characteristics of an object to be tested by using a probe card having a plurality of probes. The prober of the present invention is used to test the electrical characteristics of a plurality of devices formed on a semiconductor wafer, electronic components such as liquid crystal substrates, and electronic product. The types of object to be tested are not particularly limited. However, to more specifically explain the embodiment of the present invention, a prober for testing the electrical characteristics of devices formed on a semiconductor wafer will be described below.

As shown in FIG. 1, a prober 20 of this embodiment can comprise a loader chamber 21, prober chamber 22, control panel 23, test head TH, and tester T. The prober 20 is driven and controlled on the basis of instructions from the control panel 23. The loader chamber 21 and prober chamber 22 can perform any test on any wafer having any wafer diameter up to a maximum available diameter (e.g., 300 mm), and can be connected to any kind of tester as will be described later. Hence, the driving mechanisms and the like of the loader chamber 21 and prober chamber 22 are constructed on the basis of conventional probers.

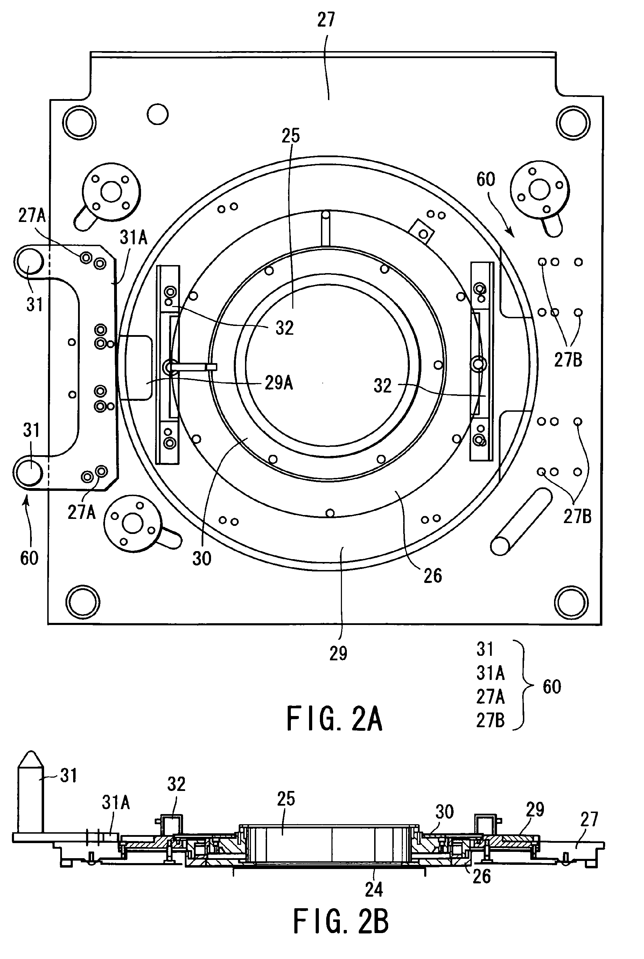

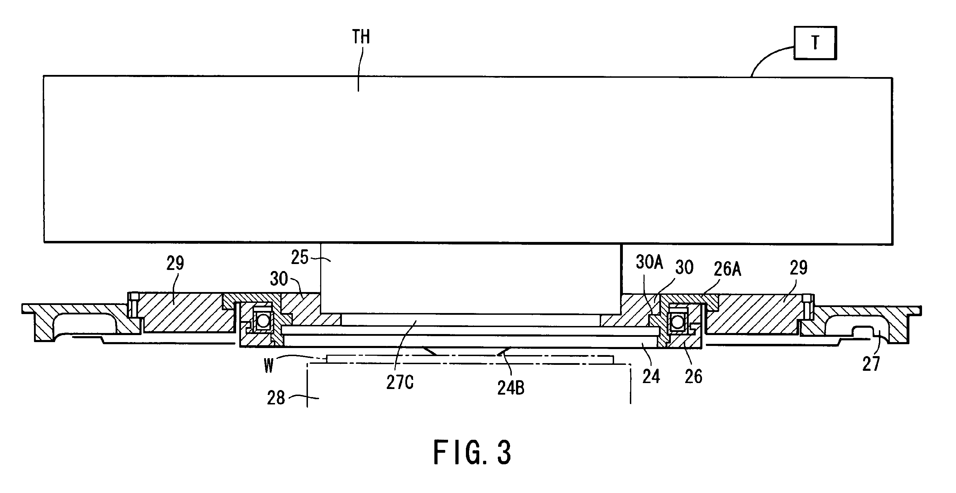

The characteristic features of this embodiment will be principally explained below. As shown in FIGS. 2A, 2B, and 3, the prober chamber 22 has a head plate 27. A mounting mechanism 60 for mounting the test head TH is placed on the head plate 27. The mounting mechanism 60 can comprise a plurality of types of mounting member (e.g., a fixing plate 31A, guide pins 31, and screw holes 27A and 27B) for mounting a plurality of types of test head.

The head plate 27 also comprises a card holding mechanism (hereinafter referred to as a "card clamp") 26. The card clamp 26 detachably supports a probe card 24 and POGO ring 25. However, the card clamp 26 may also support the probe card 24 and POGO ring 25 by using different clamping mechanisms. The POGO ring 25 has a dedicated structure for each test head TH (FIG. 3). The probe card 24 and test head TH may also be electrically connected as they are supported by the card clamp 26. A measurement signal from the tester T (FIG. 3) is supplied to electrodes of a device of a wafer W on a main chuck 28 via the test head TH and probes 24B of the probe card 24. On the basis of the measurement signal, the electrical characteristics of the device are tested.

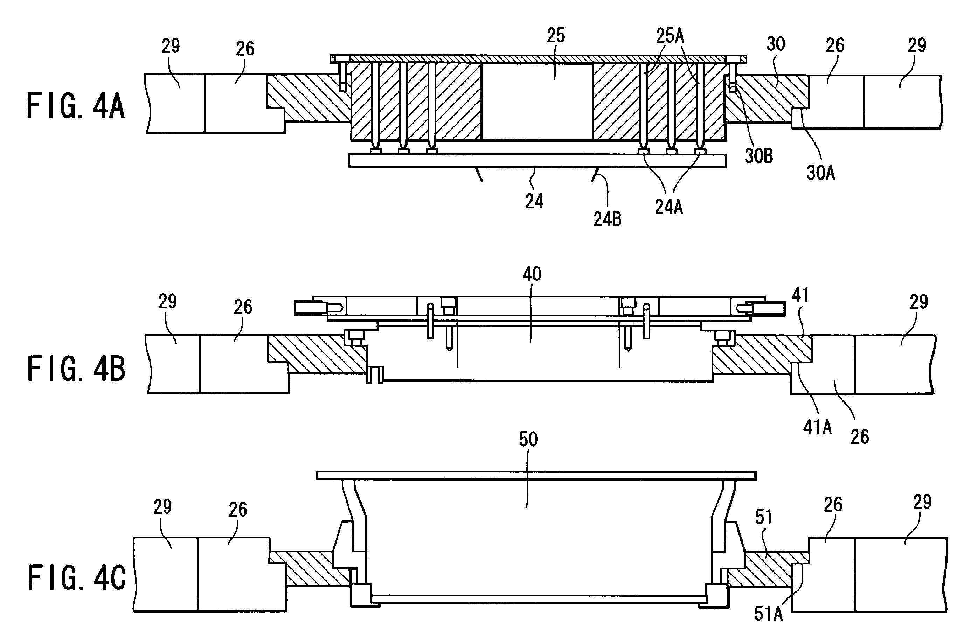

The head plate 27 preferably has an area capable of mounting the largest one of a plurality of types of test head TH. However, the test head TH may also extend from the head plate 27. As shown in FIGS. 2A and 3, a circular hole 27C is preferably formed in substantially the center of the head plate 27. The card clamp (preferably, a ring-like card clamp) 26 can be attached to the hole 27C via a member (preferably, a ring-like member) 29. The card clamp 26 can singly hold the POGO ring 25 having a specific structure, and can also hold the POGO ring 25 having another structure via a connecting ring 30. That is, each of POGO ring 25 has a structure corresponding to the type of test head, so the number, pattern of arrangement, outer diameter, and external appearance of POGO pins 25A (FIG. 4A) of each of POGO ring 25 also depend on the type of test head. As shown in FIGS. 2A and 2B, therefore, the connecting ring 30 matching the structure of the POGO ring 25 is interposed between the POGO ring 25 and card clamp 26.

The structure of the connecting ring 30 depends on the type of POGO ring. One connecting ring 30 is used for one POGO ring only. The connecting ring 30 used for the POGO ring 25 having the structure shown in FIG. 2B will be explained below. As shown in FIGS. 2B and 4A, the inner diameter of the connecting ring 30 is made substantially the same as the outer diameter of the POGO ring 25, so that the inner circumferential surface engages with the outer circumferential surface of the POGO ring 25. Screw holes 30B can be formed in the upper surface of the inner edge of the connecting ring 30. The POGO ring 25 can be integrated as it is screwed into the screw holes 30B. The outer edge of the connecting ring 30 can have a flange 30A. The flange 30A can engage with an inner flange 26A of the card clamp 26.

As shown in FIG. 3, the inner flange 26A is formed on the inner circumferential surface of the card clamp 26. The flange 30A of the connecting ring 30 engages with the flange 26A. The POGO ring 30 and card clamp 26 can be integrated by screwing the flange 30A into the inner flange 26A.

When the card clamp 26 is integrated with the POGO ring 25 to hold the probe card 24, as schematically shown in FIG. 4A, each of the POGO pins 25A elastically contacts a connecting terminal 24A formed on the edge of the upper surface of the probe card 24. By this elastic contact, the POGO ring 25 and probe card 24 are electrically connected. The probe card 24 has a plurality of probe pins 24B on its lower surface.

As shown in FIGS. 2A and 2B, the head plate 27 can have a fixing plate 31A, and guide pins 31 fixed to the fixing plate 31A to place the test head TH in a predetermined position on the head plate 27. The fixing plate 31A can be screwed into screw holes 27A formed in the head plate 27. Parts 32 necessary to connect to the test head TH oppose each other in the right and left portions on the upper surface of the ring-like member 29. To connect the test head TH to the POGO ring 25, the test head TH can be placed in a predetermined position on the head plate 27 by fitting the guide pins 31 into the holes of the test head.

As shown in FIG. 2A, a mounting mechanism 60 including guide pins 31 for positioning and mounting another type of test head, screw holes 27A and 27B for fixing the mounting members 32 and 42, and the like can be placed on the head plate 27. By the mounting mechanism 60, therefore, another type of test head TH can also be mounted on the head plate 27.

For example, FIGS. 4B and 4C are views showing POGO rings 40 and 50 to be connected to other types of test head, and connecting rings 41 and 51 of the POGO rings 40 and 50. The numbers and outer appearances of the POGO pins of the POGO rings 40 and 50 shown in FIGS. 4B and 4C are different. Therefore, the POGO rings 40 and 50 cannot be attached to the card clamp 26 shown in FIG. 3. However, the POGO ring 40 can be attached to the card clamp 26 via the connecting ring 41. The inner circumferential surface of the connecting ring 41 has a shape which can engage with and connect to the outer circumferential surface of the POGO ring 40. The outer circumferential surface of the connecting ring 41 has a flange 41A. When the flange 41A engages with the flange 26A of the card clamp 26 shown in FIG. 3, the connecting ring 41 is connected to the card clamp.

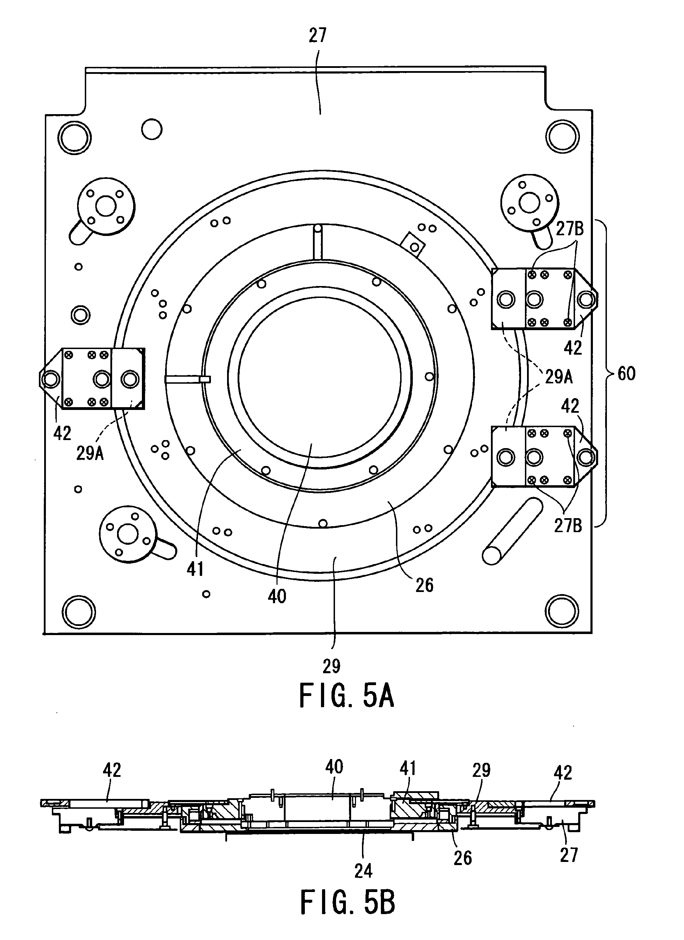

FIGS. 5A and 5B illustrate the state in which the POGO ring 40 is attached to the head plate 27. The test head connected to the POGO ring 40 has a structure different from that of the test head shown in FIG. 4A. Accordingly, guide pins and mounting parts are also different. As shown in FIGS. 2A and 2B and 5A and 5B, screw holes 27B for fixing mounting parts 42 can be formed in the head plate 27 beforehand. Cutouts 29A for attaching the parts 42 can be formed in the ring-like member 29 in advance. Processed portions 27B for fixing parts for mounting the test head for the POGO ring 50 shown in FIG. 4C can also be formed in the head plate 27.

In this embodiment, as has been described above, the different POGO rings 25, 40, and 50 can be attached to one card clamp 26 via the dedicated connecting rings 30, 41, and 51, respectively.

For example, when the POGO ring 25 is changed to the POGO ring 40 or 50 because the type of tester (or test head) is changed, the POGO ring 40 or 50 can be attached to the card clamp 26 via the dedicated connecting ring 41 or 51, respectively. If the types of all testers to be used are known, mounting mechanisms for fixing test heads of these testers are formed on the head plate 27. Consequently, each test head can be easily fixed to the head plate. Also, if an expected tester is to be installed in the prober 20, newly required mounting parts such as guide pins and mounting portions such as screw holes necessary to connect to the connecting ring and test head are designed and formed. This makes the prober 20 compatible with the unexpected tester.

In this embodiment, one type of prober 20 need only to be installed for a plurality of types of tester. This simplifies the maintenance management of the prober.

In this embodiment, the upper surface of the head plate can be made flat by making the level of the upper surface of the connecting ring equal to or lower than that of the upper surface of the card holding mechanism. Since the flatness of the head plate can be ensured, the test head and the like can be accurately and stably arranged on the upper surface of the head plate.

In this embodiment, the POGO ring is held by the flange formed inside the connecting ring. Accordingly, the level of the upper surface of the connecting ring can be readily made equal to or lower than that of the upper surface of the card holding mechanism.

In this embodiment, the use of the ring member avoids an increase in size of the connecting ring, and this facilitates the manufacture and handling of the connecting ring.

Furthermore, in this embodiment, test heads of a plurality of testers can be fixed to the head plate 27 by the minimum design change of the head plate 27. This makes one type of prober 20 compatible with a plurality of testers. Also, it is only necessary to use one type of card clamp 26 which functions as an interface when a test head and the probe card 24 are connected. This simplifies the inventory control of spare parts. Accordingly, small quantities of various products can be produced by one prober 20.

The present invention is not limited to the above embodiment. That is, the present invention includes any prober which has a card holding mechanism compatible with a plurality of types of POGO ring, and by which a plurality of types of POGO ring can be attached to the card holding mechanism via dedicated connecting rings of these POGO rings.

This embodiment can provide a highly versatile prober which can be adapted to test heads of a plurality of testers by the minimum design change and modification.

## Claims

1. A prober (20) for electrically connecting a probe card (24) to a test head (T) via a POGO ring (25), **characterized by** comprising:
a head plate (27) fixed on the prober;
a mounting mechanism (60) placed on the head plate to mount the test head, the mounting mechanism comprising a plurality of types of mounting member (31, 27A, 27B) corresponding to one of a plurality of the types of test head;
a card holding mechanism (26) to be mounted on the head plate, the card (24) holding mechanism detachably holding the probe card and the POGO ring (25) placed on the probe card; and
a connecting ring (30) interposed between the card holding mechanism and POGO ring (25), the card holding mechanism holding the POGO ring (25) via the connecting ring, and the connecting ring adaptive to a structure of the card holding mechanism and a structure of the POGO ring being selected from a plurality of types of the connecting ring.

2. A prober according to claim 1, **characterized in that** a level of an upper surface of at least one of the plurality of types of the connecting ring is equal to or less than a level of an upper surface of the card holding mechanism.

3. A prober according to claim 1, **characterized in that** the connecting ring has a flange (26A) to hold a POGO pin inside a ring structure of the connecting ring.

4. A prober according to claim 1, which further comprises a ring-like member (29) to mount the card holding mechanism on the head plate.
